# FASCICULE DE BREVET EUROPEEN

(11) **EP 2 092 618 B1**
(45) Date de publication et mention de la délivrance du brevet: **18.09.2013**
(21) Numéro de dépôt: 07847635.5
(22) Date de dépôt: 03.12.2007
(51) Int. Cl.: H01S 5/026

(54) **DISPOSITIF LASER A SOURCE LASER ET GUIDE D'ONDE COUPLES**
LASERANORDNUNG MIT GEKOPPELTER LASERQUELLE UND WELLENLEITER
LASER DEVICE WITH COUPLED LASER SOURCE AND WAVEGUIDE

(30) Priorité: 05.12.2006 FR 0655313
(43) Date de publication de la demande: 26.08.2009
(73) Titulaire: Commissariat à l'Énergie Atomique et aux Énergies Alternatives, 75015 Paris (FR)
(72) Inventeur: GILET, Philippe, 38470 Tèche (FR); TCHELNOKOV, Alexei, 38000 Grenoble (FR); FULBERT, Laurent, 38500 Voiron (FR)
(74) Mandataire: Ilgart, Jean-Christophe
(86) Numéro de dépôt international: PCT/EP2007/063123
(87) Numéro de publication internationale: WO 2008/068209

(56) Documents cités:
- GB-A- 2 325 334
- US-A- 5 278 926
- US-A- 5 673 284
- TANAKA T ET AL: "Integrated external cavity laser composed of spot-size converted LD and UV written grating in silica waveguide on Si" ELECTRONICS LETTERS, IEE STEVENAGE, GB, vol. 32, no. 13, 20 juin 1996 (1996-06-20), pages 1202-1203, XP006005333 ISSN: 0013-5194
- FANG A W ET AL: "Electrically pumped hybrid AlGaInAs-silicon evanescent laser" Optics Express Opt. Soc. America USA, vol. 14, no. 20, 2 octobre 2006 (2006-10-02), pages 9203-9210, XP002457693 ISSN: 1094-4087
- HYUNDAI PARK ET AL: "Hybrid silicon evanescent laser fabricated with silicon waveguide and III-V offset quantum wells" Optics Express Opt. Soc. America USA, vol. 13, no. 23, 14 novembre 2005 (2005-11-14), pages 9460-9464, XP002457694 ISSN: 1094-4087 cité dans la demande

## Description

### DOMAINE TECHNIQUE

La présente invention se rapporte au domaine des composants photoniques intégrés qui utilisent à la fois les propriétés des matériaux semi-conducteurs aptes à émettre de la lumière et celles des matériaux semi-conducteurs utilisés classiquement dans les circuits intégrés. Plus particulièrement, il s'agit d'un dispositif laser à source laser et guide d'onde couplés. Un tel dispositif laser peut être employé pour réaliser des liaisons optiques à grandes vitesses, des liaisons intrapuces, intracartes, en espace libre.

### ÉTAT DE LA TECHNIQUE ANTÉRIEURE

L'évolution des technologies de la microélectronique, classiquement à base de silicium, suit traditionnellement la loi de Moore. Les systèmes intégrés devenant de plus en plus complexes, les interconnexions électriques globales entre puces vont commencer à constituer un des goulots d'étranglement dans la poursuite des progrès de l'intégration. Les limitations se situeront notamment en terme de bande passante, de consommation d'énergie et de densité d'intégration.

Des voies alternatives à explorer commencent à apparaître, notamment les interconnexions optiques qui permettent principalement un accroissement de la bande passante ou la distribution d'une horloge très stable entre différents blocs synchrones.

La solution qui tend à s'imposer est de rapporter au dessus des circuits intégrés une couche optique pour faire des interconnexions globales optiques entre puces. Or le silicium dans lequel sont fabriqués les circuits intégrés ne convient pas, ses propriétés d'émission de lumière sont trop mauvaises. On commence à trouver des composants photoniques réalisés en technologie III-V ou II-VI qui coopèrent avec des composants réalisés en technologie silicium. On rappelle que la technologie III-V emploie des matériaux formés d'éléments des colonnes IIIb et Vb du tableau périodique des éléments chimiques, à savoir B, Al, Ga, In, Tl, N, P, As, Sb. La technologie II-VI emploie des matériaux formés d'éléments des colonnes IIb et VIb à savoir Zn, Cd, Te, Se, O, S, Hg. L'intérêt de cette approche est qu'elle est totalement compatible avec les technologies industrielles de la microélectronique et de la photonique les plus matures. On réalise dans les composants optiques actifs, au moins les sources laser en technologie III-V et les composants optiques passifs en technologie silicium tels que les guides d'onde en silicium ou à base de silicium. Certains composants actifs tels que les modulateurs ou les détecteurs peuvent être en germanium ou à base de germanium.

On reporte généralement sur un substrat SOI (silicon on insulator soit silicium sur isolant), par collage de type pleine plaque ou vignettage, des structures épitaxiales III-V puis on les façonne. La réalisation d'une source laser pompée électriquement sur un substrat de silicium avec un bon rendement de couplage reste toutefois un problème délicat. A ce jour, on réalise d'un côté la source laser avec une cavité amplificatrice contenant un milieu émetteur de lumière lorsqu'il est excité et on lui adjoint un guide d'onde dans lequel est injecté la lumière qui sort de la source laser. La source laser et le guide d'onde sont juxtaposés. Ce sont deux composants indépendants qui peuvent fonctionner de manière autonome. L'alignement optimal entre la source laser et le guide d'onde est très difficile à obtenir.

Dans le document « Monolithically Integrated Transverse-Junction-Stripe Laser with an External Waveguide in GaAs/AlGaAs » G.allen Vawter et al., IEEE Journal of Quantum Electronics, vol. 25, N°2, February 1989, pages 154-162, on a réalisé de manière monolithique, sur un substrat d'arséniure de gallium, une source laser qui surmonte un guide d'onde. La source laser comporte une cavité amplificatrice avec des faces qui servent de miroir et qui ont été gravées chimiquement dans le substrat. La source laser et le guide d'onde sont autonomes. Le couplage entre la source laser et le guide d'onde se fait par onde évanescente. Le pompage de la cavité amplificatrice est électrique. La réalisation des miroirs gravés dans l'arséniure de gallium est très délicate à réaliser pour obtenir une bonne qualité de réflexion.

Dans le document « Hybrid silicon evanescent laser fabricated with a silicon waveguide and III-V offset quantum walls » Hyundai Park et al. Optics Express, vol. 13, N°23, 14 November 2005, pages 9460-9464, il est décrit une source laser en matériau III-V reportée sur un substrat SOI dans lequel est façonné un guide d'onde en forme de nervure. Le couplage entre la source laser et le guide d'onde se fait par onde évanescente. Des miroirs bornant la cavité sont réalisés par sciage et polissage. La source laser et le guide d'onde sont autonomes. Le pompage de la cavité amplificatrice est optique. L'inconvénient de cette structure réside dans la réalisation des miroirs, il faut faire une étape dite de «poli-sciage», le polissage et le sciage sont simultanés. Le poli-sciage est très délicat à réaliser, il s'agit d'un procédé non collectif et difficilement industrialisable. GB 2325334 divulgue un laser à cavité externe sur un substrat SOI avec un guide d'onde.

On connaît aussi par la demande de brevet français FR-A-2 826 789 un laser intégré sur un même substrat avec un modulateur, un amplificateur ou un filtre dans lequel à la fois une structure émettrice de lumière et un réseau de diffraction sont réalisés en technologie III-V et sont mis bout à bout. Il n'y a rien en technologie silicium et ce composant optique, serait à associer à un composant technologie silicium avec les inconvénients évoqués plus haut.

### EXPOSÉ DE L'INVENTION

La présente invention a justement comme but de proposer un dispositif laser qui ne présente pas les inconvénients mentionnés ci dessus.

Un but est en particulier de réaliser un laser qui puisse être utilisé efficacement avec un circuit intégré en technologie silicium.

Un autre but est en particulier de proposer un tel dispositif laser dont le couplage entre guide d'onde et source laser est amélioré

Encore un autre but est de réaliser un dispositif laser qui ne nécessite pas d'étape de gravure de miroir dans du matériau III-V.

Pour atteindre ces buts l'invention concerne plus précisément un dispositif laser selon la revendication 1.

La structure guidante a un coeur entouré d'une gaine, la structure émettrice et le coeur sont séparés par la gaine de la structure guidante. Le coeur de la structure guidante dans la première portion forme le réseau de diffraction. Le coeur de la structure guidante au niveau de la seconde portion est le coeur du guide d'onde.

Le coeur de la structure guidante, au niveau de la seconde portion, est en silicium et pas en matériau III-V ni en matériau II-VI.

Le coeur de la structure guidante, au niveau de la première portion, comporte des zones dans le même matériau que le coeur au niveau de la seconde portion, ces zones étant alternées avec des zones en matériau diélectrique.

De préférence, la source laser est à pompage électrique.

Le coeur de la structure guidante au niveau de la seconde portion peut avoir un indice de réfraction qui est sensiblement constant.

Le réseau de diffraction est un réflecteur de type à miroirs distribués.

Le réseau de diffraction peut comporter un déphaseur.

La structure guidante peut comporter une troisième portion formant un passage adiabatique entre la première portion et la seconde portion.

La structure émettrice peut être un empilement avec, à partir de la structure guidante, une seconde couche de prise de contact électrique, une seconde couche formant gaine, une seconde couche espaceur, une couche active, une première couche espaceur, une première couche formant gaine, une première couche de prise de contact.

Chaque couche de prise de contact peut coopérer avec une plage de contact électrique.

La présente invention concerne également un procédé de réalisation d'au moins un dispositif laser comportant une source laser comprenant une structure émettrice de lumière et une structure guidante pour délivrer la lumière générée par la structure émettrice. Il comporte les étapes suivantes :
réalisation de la structure émettrice par épitaxie en technologie III-V ou II-VI,
réalisation de la structure guidante en technologie silicium avec au moins une première portion dans laquelle un réseau de diffraction est inscrit et une seconde portion qui est un guide d'onde,
assemblage de la structure émettrice et de la structure guidante par adhésion moléculaire de manière que le réseau de diffraction soit un réflecteur de la source laser et que la seconde portion délivre la lumière générée par la structure émettrice.

La structure guidante peut être réalisée dans un substrat SOI ayant deux couches en silicium séparées par une couche diélectrique, l'une des couches en silicium étant plus fine que l'autre, la structure guidante ayant un coeur qui est réalisé dans la couche en silicium la plus fine.

Le réseau de diffraction peut être obtenu par gravure de rainures dans la couche de silicium la plus fine et rebouchage avec du matériau diélectrique.

On prévoit de déposer une couche de matériau d'enterrement sur le coeur de la structure guidante pour l'enterrer.

La structure émettrice peut être réalisée sur un substrat en matériau III-V ou II-VI, en empilant depuis le substrat, successivement, une première couche de prise de contact, une première couche formant gaine, une première couche espaceur, une couche active, une seconde couche espaceur, une seconde couche formant gaine, une seconde couche de prise de contact électrique, ces couches étant en matériaux III-V ou II-VI.

La couche active peut être réalisée par empilement de plusieurs sous-couches pour obtenir un ou plusieurs puits quantiques.

Une couche d'arrêt peut être déposée sur le substrat, avant la première couche de prise de contact.

On prévoit d'éliminer le substrat en matériau III-V ou II-VI avec arrêt sur la couche d'arrêt après l'assemblage.

On prévoit aussi d'éliminer la couche d'arrêt après élimination du substrat III-V ou II-VI.

Une couche d'accrochage peut être réalisée sur la seconde couche de contact avant l'assemblage à la structure guidante.

On prévoit de préférence une étape de polissage de la couche d'accrochage et de la couche de matériau d'enterrement pour faciliter l'assemblage.

Au moins une première plage de contact électrique est déposée sur la première couche de prise de contact.

Au moins une zone de la seconde couche de prise de contact est mise à nu avant d'y déposer au moins une seconde plage de contact électrique.

Si on réalise plusieurs dispositifs laser simultanément, on peut subdiviser la structure émettrice en plusieurs morceaux par gravure au niveau de la seconde couche de prise de contact électrique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
les figures 1A, 1B montrent en coupe et en vue de dessus un exemple d'un dispositif laser de l'invention, la figure 1C étant un détail de la couche active de la structure émettrice ;
les figures 2A, 2B, 2C, 2D montrent différentes vues d'un exemple de structure guidante lors de sa fabrication ;
la figure 3 montre en coupe un exemple de la structure émettrice en cours de fabrication ;
les figures 4A à 4F montrent différentes étapes de réalisation d'un exemple de dispositif laser de l'invention à partir de l'assemblage de la structure émettrice à la structure guidante ;
les figures 5A à 5C montrent plusieurs exemples de variantes de la structure guidante ;
la figure 6 montre un circuit intégré CMOS sur lequel on a repéré les lieux où le dispositif laser de l'invention pourrait être placé.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

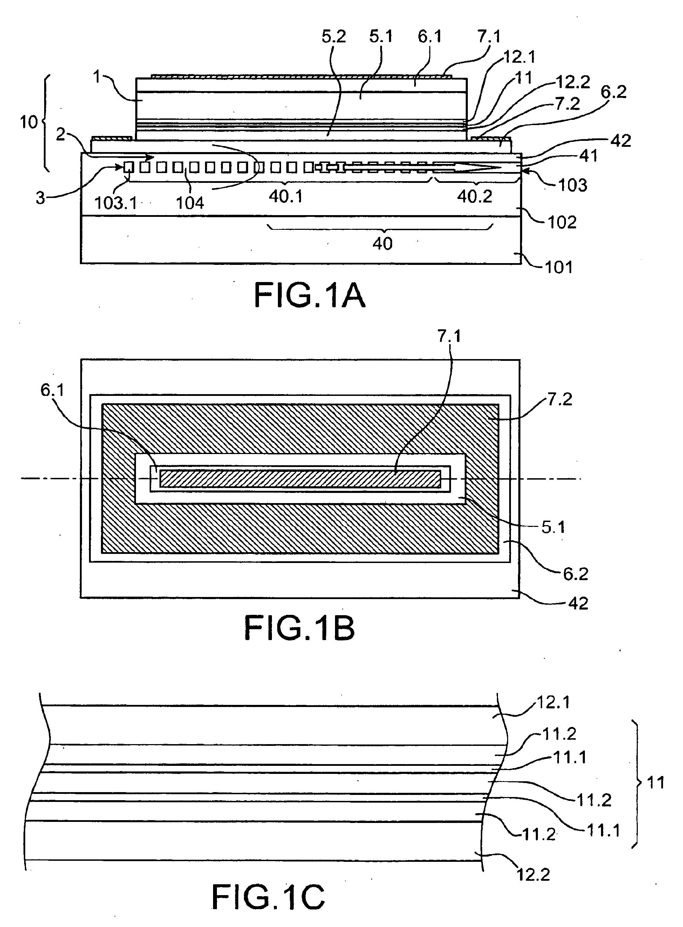

On va maintenant se référer aux figures 1A et 1B qui montrent en coupe un dispositif laser selon l'invention en coupe et en vue de dessus.

Ce dispositif laser comporte une source laser 10 et une structure guidante 40 dans laquelle pourra se propager un faisceau laser (schématisé par la flèche F sur la figure 1A) émis par la source laser 10. La source laser 10 inclut une structure émettrice 1, coopérant avec une cavité amplificatrice 2. Cette structure émettrice 1 possède un ou plusieurs puits quantiques et est susceptible d'émettre de la lumière lorsqu'elle est excitée. Cette structure émettrice 1 est réalisée en technologie III-V ou II-VI. La structure émettrice 1 coopère avec un réflecteur qui est formé par un ou plusieurs réseaux de diffraction 3 pour parachever la cavité amplificatrice 2.

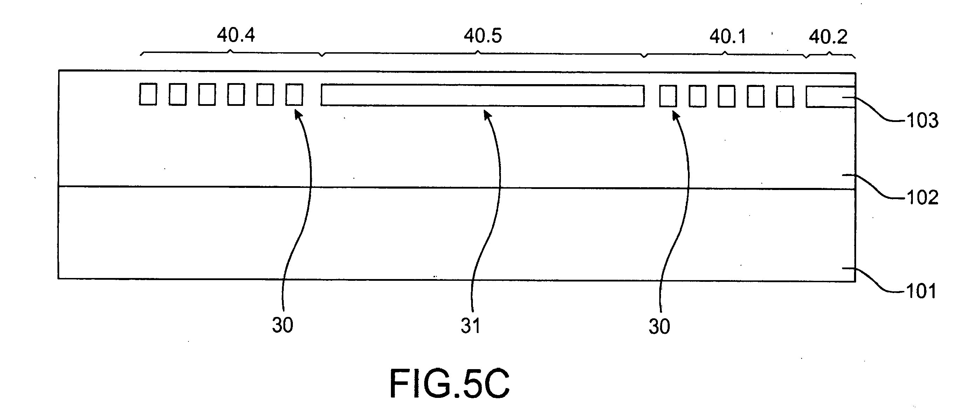

En choisissant convenablement les paramètres des réseaux de diffraction 3, on obtient une source laser 10 à rétroaction distribuée connue sous le sigle DFB (abréviation anglo-saxonne de distributed feed back). Sur les figures 1A, 1B, la source laser est à rétroaction distribuée tandis que sur la figure 5C montrant un example qui n'appartient pas à l'invention, elle est à réflecteurs de Bragg distribués. Cette figure 5C sera décrite ultérieurement. Sur les figures 1, la cavité 2 est distribuée tout le long d'un seul réseau de diffraction 3.

De tels réseaux de diffraction utilisés dans les lasers monolithiques ne posent pas de problème à l'homme du métier qui peut se référer par exemple à l'ouvrage général « Distributed feedback semiconductors lasers » de J. Caroll, J. Whiteaway, D. Plumb, SPIE Press 1998, SPIE IBSN : 08194 2660 1.

Lorsque la structure émettrice 1 émet de la lumière, cette lumière se couple au réseau de diffraction 3 par onde évanescente. Cette lumière est modulée par le réseau de diffraction 3 qui est sous-jacent à la structure émettrice 1. Le mode optique prenant naissance dans la structure émettrice 1 au niveau d'une couche active 11 déborde de part et d'autre de cette couche active 11. Le profil optique du mode est illustré sur la figure 1A.

Selon une caractéristique de la présente invention, le réseau de diffraction 3 est intégré dans la structure guidante 40. Plus précisément, la structure guidante 40 comporte au moins une première portion 40.1 dans laquelle est inscrit le réseau de diffraction 3 et une seconde portion 40.2 qui est un guide d'onde au moyen duquel le faisceau laser est émis hors de la source laser 10. La seconde portion 40.2 est localisée en aval de la première portion 40.1. La structure guidante 40 comporte un coeur 41 contenu dans une gaine 42, le coeur au niveau la première portion 40.1 forme le réseau de diffraction 3. Le coeur 41 au niveau de la seconde portion 40.2 de la structure guidante est le coeur du guide d'onde, il a un indice de réfraction sensiblement constant. La structure émettrice 1 et le coeur 41 de la structure guidante 40 sont séparés par la gaine 42 de la structure guidante 40.

Le réseau de diffraction 3 correspond à une partie à variation périodique de l'indice de réfraction du coeur de la structure guidante, il formé d'une succession alternée d'une ou plusieurs premières zones 103.1 ayant un premier indice de réfraction et d'une ou plusieurs secondes zones 104 ayant un second indice de réfraction différent du premier indice de réfraction. Il est à pas, de préférence, sensiblement constant.

La lumière sort de la source laser 10 en se propageant dans la structure guidante 40 depuis la première portion 40.1 logeant le réseau de diffraction 3 vers la seconde portion 40.2 de la structure guidante 40.

La structure guidante 40 est réalisée en technologie silicium. Le coeur 41 de la structure guidante 40 dans la seconde portion 40.2 qui jouxte le réseau de diffraction 3 est en silicium, ce choix est fait parce que le coeur n'a pas besoin d'avoir de bonnes propriétés d'émission de lumière à l'inverse de la structure émettrice 1.

Au niveau du réseau de diffraction 3, on prévoit que les premières zones 103.1 soient réalisées également en silicium. Les secondes zones 104 seront elles en diélectrique tel que le dioxyde de silicium ou le nitrure de silicium. On choisit pour les secondes zones 104 un matériau qui n'absorbe pas ou peu la lumière et qui possède un indice de réfraction ayant un écart le plus grand possible avec celui des premières zones. Les premières zones 103.1 ont un indice de réfraction qui est plus grand que celui des secondes zones 104.

Les différentes portions 40.1, 40.2 de la structure guidante 40 seront réalisées en même temps par des étapes communes.

Parmi la structure émettrice 1 et la structure guidante 40, seule la structure émettrice 1 est réalisée en technologie III-V ou II-VI. Cela permet d'obtenir le gain pour la source laser 10. La structure guidante 40 n'est pas en technologie III-V ou II-VI. Par rapport à l'art antérieur, cette structure est avantageuse car on n'a pas besoin de réaliser de réflecteur dans le matériau III-V ou II-VI, ce qui représente toujours une opération délicate.

Le réseau de diffraction 3 sert à la fois de coupleur vers la seconde portion 40.2 de la structure guidante 40 et de réflecteur pour la cavité amplificatrice 2. La structure émettrice 1 est donc le milieu amplificateur de la source laser 10 et le réseau de diffraction 3 est un réflecteur qui permet d'obtenir l'effet laser.

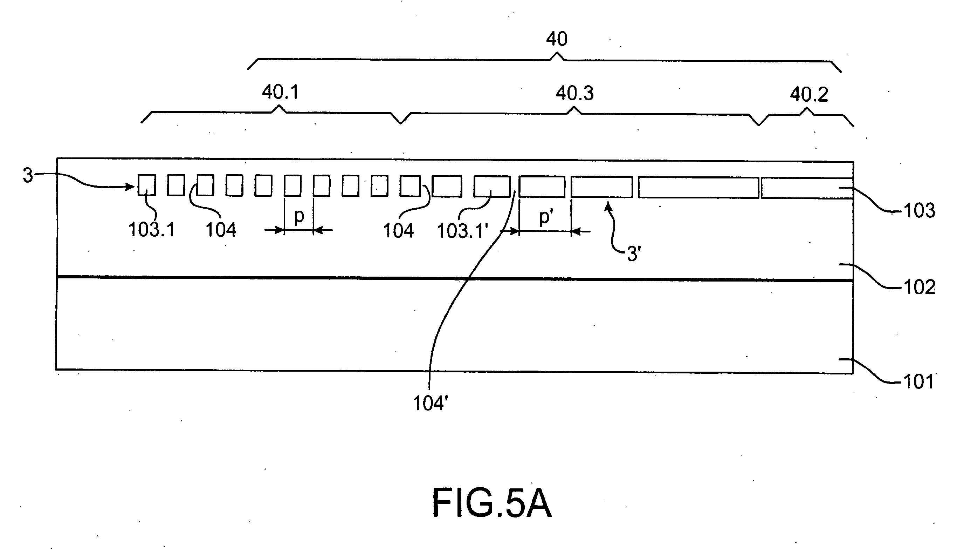

On va s'intéresser maintenant, en variantes à d'autres exemples de la structure guidante 40 en se référant aux figures 5A à 5C.

Sur la figure 5A, la structure guidante 40 comporte une portion intermédiaire 40.3 insérée entre la première portion 40.1 et la seconde portion 40.2. Cette portion intermédiaire 40.3 loge une transition adiabatique 3' entre le réseau de diffraction 3 et le guide d'onde 40.2. Cette transition adiabatique 3' se trouve au niveau du coeur de la structure guidante 40, elle est réalisée par une succession alternée de premières zones 103.1' et de secondes zones 104' des indices de réfraction différent comme celles du réseau de diffraction 3, mais maintenant le pas de l'alternance n'est plus constant, il est progressivement croissant depuis le réseau de diffraction 3 vers le guide d'onde 40.2. On a référencé p le pas du réseau de diffraction 3 et p' celui de la transition adiabatique 3'. De plus, outre l'accroissement du pas p', on a concomitamment une diminution de la seconde zone 104'. Cette troisième portion 40.3 réalise une adaptation de modes entre le mode de la première portion 40.1 et le mode de la seconde portion 40.2.

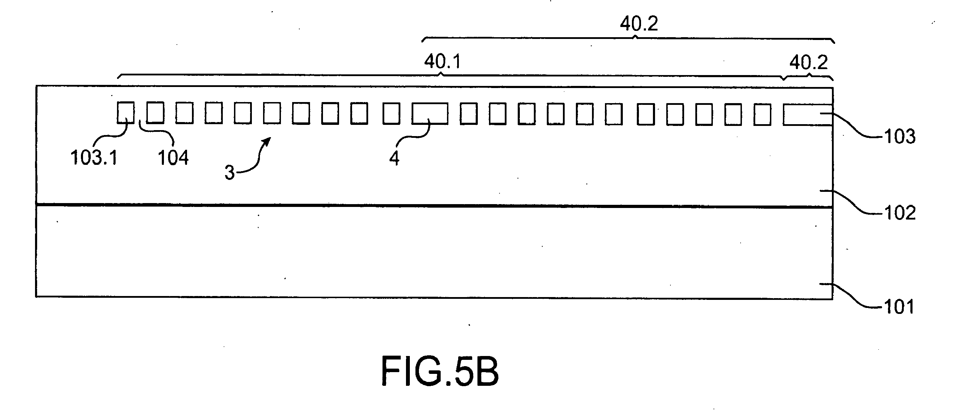

Sur la figure 5B, on a représenté un déphaseur 4 au sein du réseau de diffraction 3. Ce déphaseur 4 est localisé dans une zone centrale du réseau de diffraction 3. Ce déphaseur 4 situé entre deux secondes zones 104 est réalisé dans le matériau des premières zones 103.1, dans notre exemple le silicium. Sa longueur sera plus grande que celle d'une première zone 103.1, préférentiellement cette longueur sera sensiblement le double.

Sur la figure 5C, montrant un example illustratif, comme cela a déjà été évoqué, la structure guidante 40 comporte des première et seconde portions 40.1, 40.2, la seconde portion 40.1 étant complétée par deux portions supplémentaires 40.4, 40.5 successives dont la première 40.4 inclut un second réseau de réfraction 30 et la seconde 40.5 inclut une cavité amplificatrice 31. Le second réseau de diffraction 30 et la cavité amplificatrice 31 sont formés par le coeur 41 de la structure guidante 40. La cavité amplificatrice 31 est localisée entre le premier réseau de diffraction 3 de la première portion 40.1 et le second réseau de diffraction 30 de la première portion supplémentaire 40.4. Les deux réseaux de diffraction 3 et 30 sont de préférence identiques. La cavité 31 est réalisée dans le matériau des premières zones 103.1, dans l'exemple décrit, le silicium, sa longueur est beaucoup plus grande que celle des premières zones des réseaux de diffraction et même plus grande que celle du déphaseur.

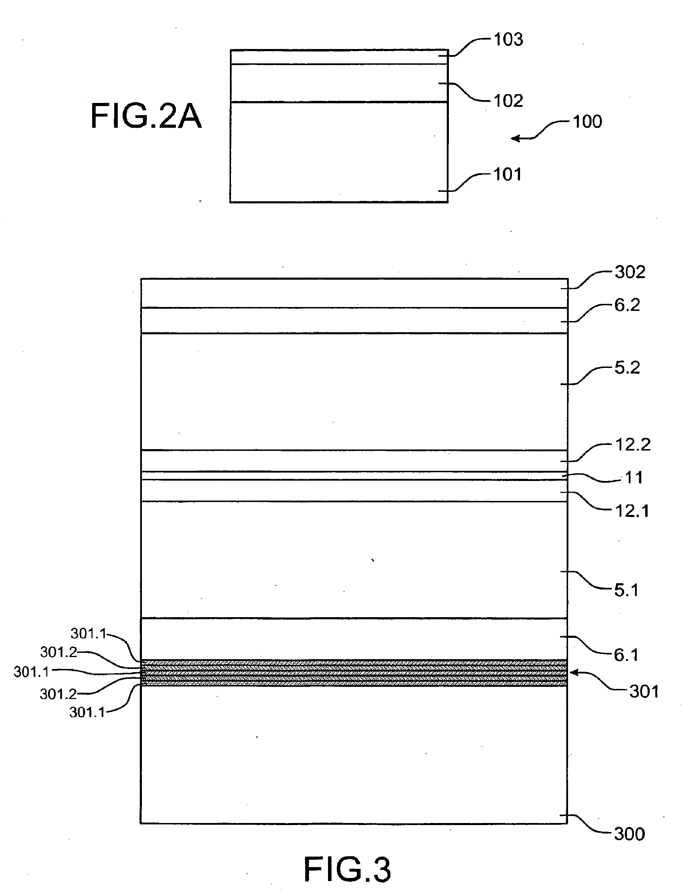

La structure émettrice 1 comporte un empilement de couches qui est illustré sur la figure 3, avec une couche active 11 à un ou plusieurs puits quantiques, insérée entre une première couche espaceur 12.1 et une seconde couche espaceur 12.2. La structure émettrice 1 comporte en dessous et au dessous des couches espaceurs 12.1, 12.2, une première et une seconde couche formant gaine 5.1, 5.2.

Si la couche active 11 n'a qu'un puits quantique, elle est alors formée d'une sous-couche de InGaAs, par exemple, prise en sandwich entre deux sous-couches en GaAs par exemple. Si la couche active 11 comporte plusieurs puits quantiques, dans la même optique, elle est formée d'un empilement alterné de sous-couches de GaAs et de InGaAS ; pour m puits quantiques, on aura m couches de InGaAs 11.1 et m+1 couches de GaAs 11.2. La figure 1C montre de manière plus détaillée la couche active 11 à deux puits quantiques avec ses sous-couches 11.1, 11.2 prise en sandwich entre les couches espaceurs 12.1, 12.2.

L'empilement de la structure émettrice 1 se termine par une première et une seconde couche 6.1, 6.2 de prise de contact électrique utilisées pour la polarisation électrique de la couche active 11. Ces couches de prise de contact 6.1, 6.2 ont des dopages de types différents. La première et la seconde couche formant gaine 5.1, 5.2 sont aussi dopées et elles ont des dopages de type différent. La première couche de prise de contact 6.1 et la première couche formant gaine 5.1 ont des dopages de même type. Il en est de même pour la seconde couche de prise de contact 6.2 et la seconde couche formant gaine 5.2. On suppose que la seconde couche de prise de contact 6.2 possède un dopage de type n+ et que la première couche de prise de contact 6.1 possède un dopage de type p+. L'inverse serait bien sûr possible. Il en est de même pour toutes les couches dopées, tous les dopages pourraient être inversés. Les couches de prise de contact 6.1, 6.2 coopèrent, pour chaque structure émettrice, chacune, avec une plage de contact 7.1, 7.2 respectivement.

Les couches de prise de contact 6.1, 6.2 peuvent être par exemple en arséniure de gallium, dopées avec du silicium, par exemple, pour le dopage de type n+ et dopées avec du carbone, par exemple, pour le dopage de type p+. Les concentrations de dopant de type n+ peuvent être de l'ordre de 3E18.cm⁻³ et celles de dopant de type p+ peuvent être de type 3E19.cm⁻³. Leur épaisseur peut être de l'ordre de 100 nm.

La couche active 11 est non dopée. L'épaisseur de ses sous-couches 11.2 peut être d'environ 20 nanomètres et de ses sous-couches 11.1 d'environ 7 nanomètres.

Les deux couches espaceurs 12 peuvent, par exemple, être réalisées en GaAs non dopé et avoir une épaisseur de l'ordre de 100 nanomètres.

Les couches formant gaine 5.1, 5.2 peuvent être, par exemple, en Ga_{0,7}Al_{0,3}As, elles sont dopées avec par exemple du silicium pour celle qui est de type n et du carbone pour celle qui est de type p et leur dopage peut avoir une concentration de l'ordre de 5E17.cm⁻³. Dans l'exemple décrit, leur épaisseur de l'ordre de 1,7 micromètre pour celle qui est la plus éloignée du réseau de diffraction 3 et de l'ordre de 500 nm pour celle qui est la plus proche du réseau de diffraction 3. Avec de telles épaisseurs différentes, la structure est dissymétrique et le mode optique est décentré vers le réseau de diffraction 3.

L'empilement est réalisé sur un substrat en technologie III-V ou II-VI 300, par exemple en arséniure de gallium GaAs non intentionnellement dopé ou en phosphure d'indium InP.

D'autres exemples de matériaux pour la structure émettrice vont être donnés. Il peut s'agir d'alliages d'éléments des colonnes IIb et VIb du tableau périodique des éléments chimiques, comme par exemple ZnO et ZnSe ou d'alliages d'azote N avec un élément des colonnes IIIb du tableau périodique des éléments chimiques, comme par exemple GaN ou GaAlN. Par alliage on entend un composé d'un métal ou d'un métalloïde avec un ou plusieurs autres éléments.

La structure guidante 40 dans laquelle est inscrit le réseau de diffraction 3 peut être formée à partir d'un substrat SOI illustré sur la figure 2A. Un tel substrat SOI 100 comporte classiquement une couche en dioxyde de silicium 102 prise en sandwich entre deux couches en silicium 101, 103 dont une référencée 103 est plus fine que l'autre. La couche la plus fine 103 est en silicium polycristallin, monocristallin ou même amorphe. En variante, l'homme du métier pourrait sans difficulté se passer de substrat SOI et créer la structure guidante à partir de silicium et de diélectrique.

On suppose toutefois que l'exemple décrit utilise un substrat SOI. Le coeur 41 de la structure guidante 40 est formé au niveau de la couche 103 la plus mince de silicium.

La gaine 42 est formée d'un côté par la couche isolante 102 du substrat SOI 100 et pour le reste par un matériau de bouchage 104 et par un matériau d'enterrement 105.

Le réseau de diffraction 3, puisque c'est une partie du coeur de la structure guidante 40, utilise à la fois la couche 103 la plus mince de silicium du substrat SOI 100 et le matériau de bouchage 104. Il fonctionne sur le principe de variations périodiques d'indices de réfraction comme on l'a déjà vu, les indices de réfraction étant ceux du silicium de la couche 103 la plus mince et du matériau de bouchage 104 qui dans l'exemple décrit est du dioxyde de silicium. On réalise dans la couche de silicium 103 des motifs périodiques en creux, par exemple des rainures sensiblement rectangulaires et parallèles, que l'on remplit de matériau de bouchage 104. Ces rainures peuvent mettre à nu ou non la couche 102 en dioxyde de silicium. On façonne lors de la même étape la forme du coeur 41 de la seconde portion 40.2 de la structure guidante 40 qui forme le guide d'onde. On obtient alors la succession alternée des premières zones 103.1 qui sont des bandes en silicium et des secondes zones 104 qui sont les rainures pleines de matériau de bouchage. Le matériau d'enterrement 105 contribue à terminer la gaine de la structure guidante 40 et donc à enterrer le réseau de diffraction 3 et le coeur du guide d'onde.

Le matériau de bouchage 104 peut être le même que le matériau d'enterrement 105 par exemple du dioxyde de silicium ou être différent par exemple du nitrure de silicium. Le matériau d'enterrement 105 sert aussi pour faciliter l'accrochage entre la structure guidante 40 et la structure émettrice 1. La référence 105 représente indifféremment la couche d'enterrement et le matériau d'enterrement.

La couche 102 de dioxyde de silicium du substrat SOI 100 peut avoir une épaisseur de l'ordre de 3 micromètres, la couche de silicium la plus mince 103 du substrat SOI 100 peut avoir une épaisseur de l'ordre de d'environ 220 nanomètres. Le matériau de bouchage 104 a sensiblement la même épaisseur. La couche d'.enterrement 105 peut également avoir une épaisseur de l'ordre de 100 nanomètres. Il n'y a pas de contrainte sur l'épaisseur de l'autre couche 101 de silicium du substrat.

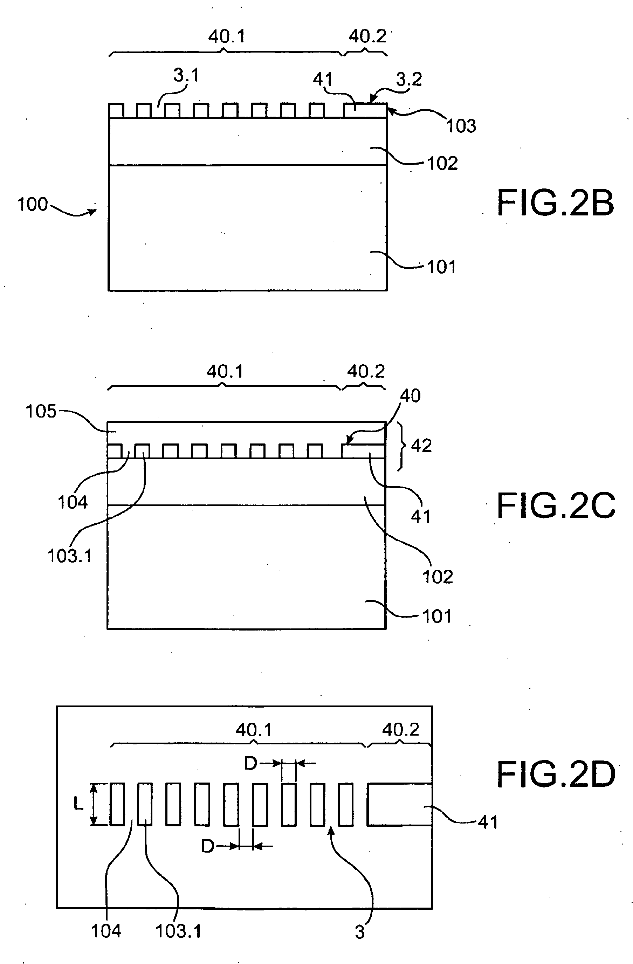

Le réseau de diffraction 3 sert de miroir réparti. Il travaille au premier ordre. Dans un mode de réalisation avantageux illustré sur la figure 2D, la largeur L du coeur de la structure guidante 40, c'est à dire la largeur du réseau de diffraction 3 et également celle du coeur du guide d'onde dans la seconde portion 40.2, pourra être de 540 nanomètres pour une longueur d'onde λ de travail de 1310 nanomètres et de 500 nanomètres pour une longueur d'onde λ de 1550 nanomètres. Le facteur de remplissage pourra être de 0,5 ce qui signifie que les premières zones 103.1 seront espacées d'une distance égale à leur largeur D. Pour une longueur d'onde λ de 1310 nanomètres, cette largeur D vaudra environ 185 nanomètres et pour une longueur d'onde λ de 1550 nanomètres, cette largeur D vaudra environ 240 nanomètres. Ces valeurs correspondent à un exemple et elles ne sont données qu'à titre indicatif. D'autres valeurs numériques seraient possibles bien entendu.

Dans la demande de brevet FR-A-2 826 789, le réseau de diffraction était directement réalisé dans une portion de la couche active de la structure émettrice de lumière.

Dans le dispositif laser objet de l'invention, le réseau de diffraction 3 et la structure émettrice de lumière 1 sont empilés l'un sur l'autre.

On va maintenant décrire plus en détail un exemple de procédé de réalisation d'un dispositif laser selon l'invention. On va réaliser séparément la structure guidante et la structure émettrice de la source laser. La source laser 10 et la structure guidante 40 ne fonctionnent pas de manière autonome, la première portion de la structure guidante 40 est intégrée dans la source laser 10, elle coopère avec la structure émettrice et intègre le réseau de diffraction.

Pour réaliser la structure guidante 40 et donc le réseau de diffraction, on part, dans l'exemple décrit, d'un substrat SOI 100 illustré sur la figure 2A. Il peut s'agir d'une plaquette employée en technologie CMOS, d'un diamètre de l'ordre de 200 millimètres sur laquelle vont être réalisés un ou plusieurs guides d'ondes. Dans ce contexte, la structure émettrice pourra avoir une emprise d'environ un centimètre par un centimètre sur la plaquette.

On va délimiter par lithographie suivie d'une étape de gravure, dans la couche la plus fine 103, le contour du coeur 41 de la structure guidante 40, c'est-à-dire le coeur du guide d'onde et les motifs du réseau de diffraction 3 de la première portion 40.1. Si la structure guidante comporte d'autres portions comme celle logeant la transition adiabatique ou celle logeant la cavité et celle logeant le second réseau de diffraction, on délimite de la même manière le coeur de ces portions. On n'a pas représenté ces variantes dans un souci de simplicité.

La gravure représentée sur la figure 2B peut être une gravure sèche par plasma connue sous la dénomination de gravure RIE (abréviation anglo-saxonne de reactive ion etching soit gravure ionique réactive). On réalise en fait, au niveau de la première portion, une série de rainures 3.1 sensiblement parallèles dans la couche de silicium 103 pour réaliser le réseau de diffraction et un ruban 3.2 sensiblement perpendiculaire pour la seconde portion. Sur la figure 2B, la gravure s'arrête sur la couche de dioxyde de silicium 102 mais ce n'est pas une obligation, elle pourrait s'arrêter dans la couche de silicium 103. On va ensuite déposer du matériau de bouchage 104 pour parfaire le réseau de diffraction, ce matériau de bouchage remplissant les rainures 3.1. On se réfère à la figure 2C. Ce matériau de bouchage 104 entoure également latéralement le ruban 3.2. On enterre ensuite le réseau de diffraction et le ruban en le recouvrant de matériau 105 d'enterrement. Ce matériau d'enterrement 105 contribue à former la gaine 42 de la structure guidante.

Le dépôt du matériau de bouchage 104 et du matériau 105 d'enterrement peut ne faire qu'une seule étape. Le dépôt de ce matériau qui dans l'exemple est du dioxyde de silicium peut se faire par PECVD (abréviation anglo-saxonne de Plasma Enhanced Chemical Vapour Deposition soit dépôt chimique en phase vapeur assistée par plasma). Il est illustré aux figures 2C et 2D. Cette couche d'enterrement 105 en dioxyde de silicium sert également de couche d'accrochage.

Il est préférable de prévoir, pour améliorer l'accrochage, une étape d'aplanissement par exemple par polissage mécano-chimique de la couche d'enterrement 105. L'épaisseur totale de la couche d'enterrement 105 peut être de l'ordre de 100 nanomètres alors que typiquement on pourra avoir déposé 1, 5 micromètre de dioxyde de silicium pour à la fois le bouchage et l'enterrement. Cette étape d'aplanissement peut se faire au feutre humide. On réalise ainsi un polissage qui active la couche d'enterrement 105 pour faciliter l'accrochage de la structure émettrice 1 comme on le verra ultérieurement. On s'arrange toutefois pour que la couche d'enterrement 105 soit la plus faible possible.

Par ailleurs, on va réaliser la structure émettrice 1 en technologie III-V ou II-VI par épitaxie de type MOCVD (abréviation de Metal-Organic Chemical Vapor Deposition soit dépôt chimique en phase vapeur de précurseurs organo-métalliques) ou de type MBE (abréviation de molecular beam epitaxy soit épitaxie par jets moléculaires) sur un substrat par exemple de GaAs non intentionnellement dopé référencé 300 sur la figure 3. L'épaisseur du substrat 300 n'est pas contraignante, c'est un substrat sacrificiel et son élimination ne doit pas poser trop de problème. Sur un tel substrat 300 adapté, l'homme du métier pourra faire croître par épitaxie, sans problème les couches énumérées plus haut à savoir depuis le substrat 300 dans l'ordre : la première couche de prise de contact 6.1, la première couche formant gaine 5.1, la première couche espaceur 12.1, la couche active 11, la seconde couche espaceur 12.2, la seconde couche formant gaine 5.2, la seconde couche de prise de contact 6.2.

Il est préférable de prévoir entre le substrat 300 et la première couche de prise de contact 6.1 une couche d'arrêt 301 qui facilitera ultérieurement le retrait du substrat 300 sans attaque de la première couche de prise de contact 6.1. La couche d'arrêt 301 peut être un « super réseau », c'est-à-dire un multicouche périodique formé par la répétition d'un motif élémentaire constitué de couches successives chimiquement différentes. On peut prévoir des sous-couches de GaAs et de AlAs, référencées respectivement 301.1, 301.2. On peut ainsi prévoir cinq sous-couches de chaque matériau en un empilement alterné. L'épaisseur totale de chaque sous-couche 301.1, 301.2 est d'environ 100 nanomètres.

On va recouvrir ensuite la seconde couche de prise de contact 6.2 d'une couche d'accrochage 302 de dioxyde de silicium par exemple pour faciliter l'accrochage avec la structure guidante. L'épaisseur de cette couche d'accrochage 302 sera la plus faible possible, par exemple environ 200 nanomètres. Le dioxyde de silicium de la couche d'accrochage 302 peut être déposée par PECVD. Comme précédemment, la couche d'accrochage 302 va être polie mécano-chimiquement par exemple au feutre humide pour activer sa surface.

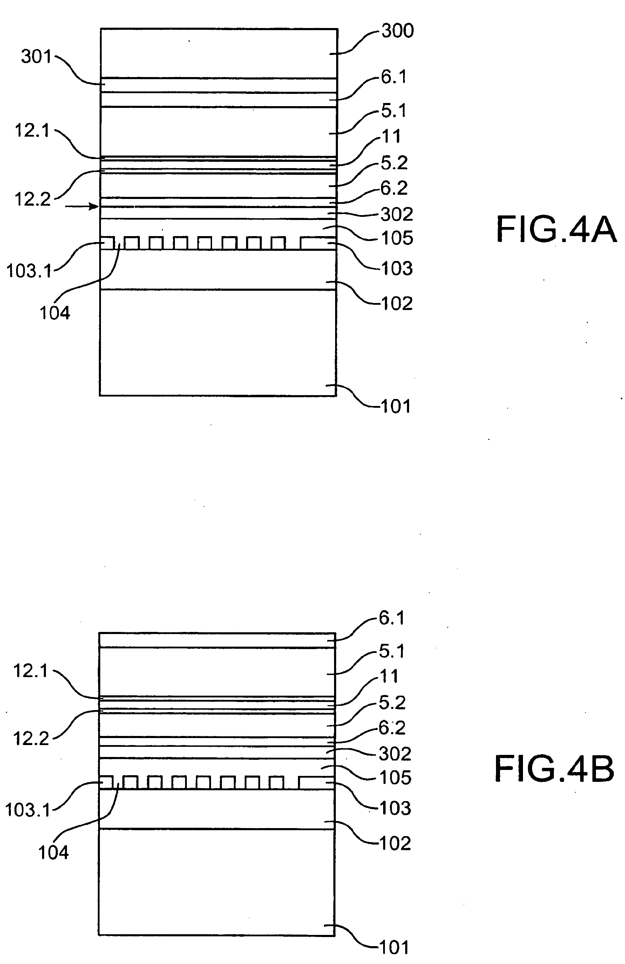

Ensuite on va mettre en contact mécanique les deux faces activées et les assembler par collage moléculaire. Le collage moléculaire est une technologie d'assemblage de deux matériaux qui connaît une utilisation croissante en microélectronique et micro technologie. Elle est basée sur l'adhésion spontanée de deux surfaces indépendamment de leurs structures cristallines respectives et lorsque celles-ci sont suffisamment planes et peu rugueuses. Le collage se fait par propagation d'une onde mécanique. Il est illustré à la figure 4A. L'interface de collage est illustré par la flèche. On prévoit de préférence un recuit à une température comprise entre environ 200°C et 600°C pendant plusieurs heures pour fortifier le collage.

On va ensuite éliminer le substrat 300 utilisé pour réaliser la structure émettrice 1. Cette élimination peut se faire en plusieurs temps d'abord un amincissement par rodage puis polissage mécanique jusqu'à une épaisseur d'environ 50 micromètres, puis par une gravure chimique avec une solution à base d'acide citrique par exemple et arrêt sélectif sur la couche d'arrêt 301. On va ensuite éliminer à son tour la couche d'arrêt 301 par exemple par gravure chimique sélective avec une solution à base d'acide chlorhydrique par exemple. On peut se référer à la figure 4B.

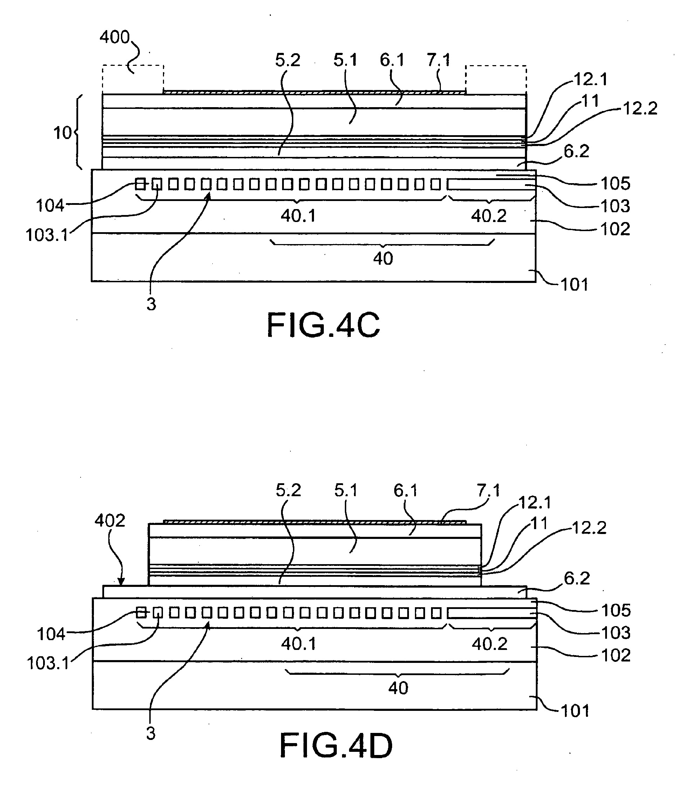

Il ne reste plus qu'à réaliser les plages de contact électrique 7.1, 7.2 sur les deux couches de prise de contact 6.1, 6.2. On peut commencer par réaliser la plage de contact 7.1 qui coopère avec la première couche de prise de contact 6.1 et est localisée au sommet de la structure émettrice 1. Elle peut par exemple être un multicouche Ti-Pt-Au si elle est de type p. On peut la faire par dépôt-retrait (lift-off en anglais). En effet, la technologie des composants III-V ou II-VI se distingue de celle du silicium par l'utilisation de métaux difficiles à graver. De ce fait, contrairement à la technologie du silicium où, pour former une plage de contact électrique, on dépose un film métallique sur toute la surface de l'échantillon et on élimine ensuite les parties indésirables au moyen d'une gravure à travers un masque de résine, en technologie dépôt-retrait, on réalise un masque en résine 400 avant de déposer le métal qui est déposé seulement dans les parties désirées. En éliminant le masque et le métal qui a été déposé sur sa surface, on obtient la plage de contact recherchée 7.1. Le dépôt métallique peut se faire par évaporation. Le masque de résine est esquissé en pointillés avec la référence 400 sur la figure 4C.

Pour pouvoir réaliser la seconde plage de contact 7.2 qui coopère avec la seconde couche de prise de contact 6.2, il faut mettre à nu localement cette seconde couche de prise de contact 6.2 pour pouvoir atteindre sa surface sur au moins une zone 402. On se réfère à la figure 4D. Cette mise à nu locale de la seconde couche de prise de contact 6.2 peut se faire par gravure par exemple de type gravure ionique réactive RIE (abréviation anglo-saxonne de reactive ion etching) ou gravure chimique. Cela revient à façonner au moins une mesa qui délimite un motif de la partie active 10. On peut lui donner la forme d'un ruban. Plusieurs parties actives distinctes peuvent ainsi être délimitées l'une à côté de l'autre, si on a prévu plusieurs guides d'ondes.

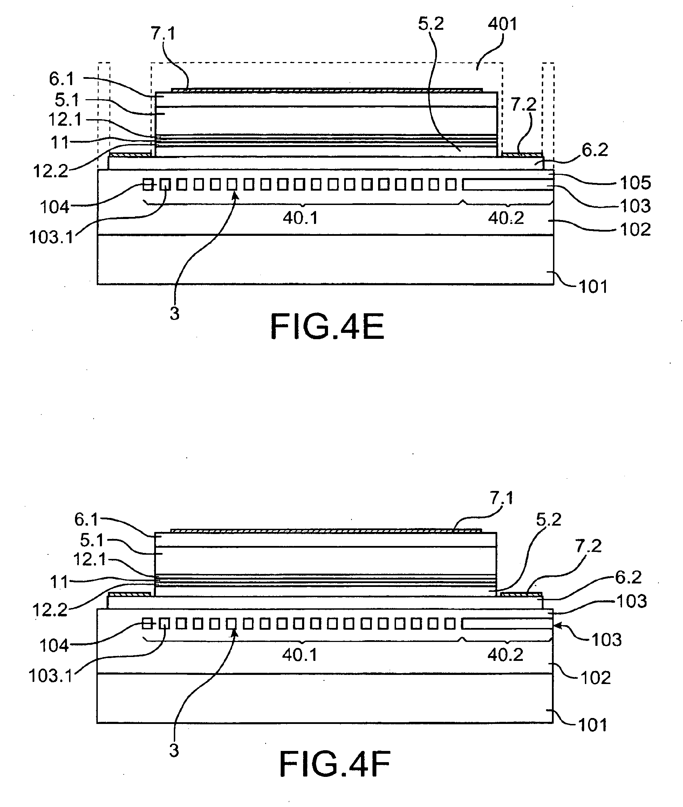

On peut ensuite réaliser, pour chaque dispositif laser, la seconde plage de contact 7.2 sur la zone de la seconde couche de prise de contact 6.2 mise à nu. On se réfère à la figure 4E. Cette seconde plage de contact 7.2 peut aussi être réalisée par lift-off en fond de gravure. Le masque utilisé est esquissé en pointillés et il porte la référence 401 sur la figure 4E. Ce masque 401 recouvre aussi la mesa. La seconde plage de contact 7.2, si elle est de type n, peut être réalisée par un multicouche Ni-Ge-Au-Ni-Au. Il est préférable de prévoir un recuit rapide des plages de contact 7.1 , 7.2, pour faire interdiffuser les espèces, par exemple à une température comprise entre environ 350°C et 450°C pendant quelques minutes.

S'il y a plusieurs structures émettrices sur le substrat 101, on prévoit une étape d'isolation des structures émettrices les unes par rapport autres, par une étape de gravure de la seconde couche de prise de contact 6.2 jusqu'à mettre à nu le matériau d'enterrement 105. Cette gravure se fait au-delà de la seconde plage de contact 7.2 par rapport à la mesa. Cette gravure peut se faire par gravure ionique réactive. La structure émettrice réalisée est alors subdivisée en plusieurs parties. Elle est illustrée à la figure 4F.

L'ordre des étapes qui vient être décrit n'est pas limitatif, il est possible de réaliser, par exemple, l'étape de gravure visant à isoler électriquement plusieurs structures émettrices avant de réaliser la seconde plage de contact 7.2 ou bien de réaliser la gravure visant à mettre à nu la seconde couche de prise de contact 6.2 avant de réaliser la première plage de contact 7.1 ou même de réaliser la seconde plage de contact électrique avant de réaliser la première plage de contact électrique.

En conclusion la source laser est couplée dans la structure guidante de façon intrinsèque. Le pompage est électrique. La source laser et le guide d'onde ne sont pas autonomes comme dans l'art antérieur. On peut parler de dispositif laser couplé.

On a un couplage optimal car le réseau de diffraction et le guide d'onde sont réalisés par les mêmes étapes de lithographie. Le réseau de diffraction et le coeur du guide d'onde sont parfaitement alignés. Cet alignement est le reflet des tolérances de côtes des masques. Cet alignement est meilleur que si l'on utilisait deux masques, un pour chaque portion de la structure guidante. On n'a pas besoin de graver du matériau III-V ou II-VI pour faire des miroirs.

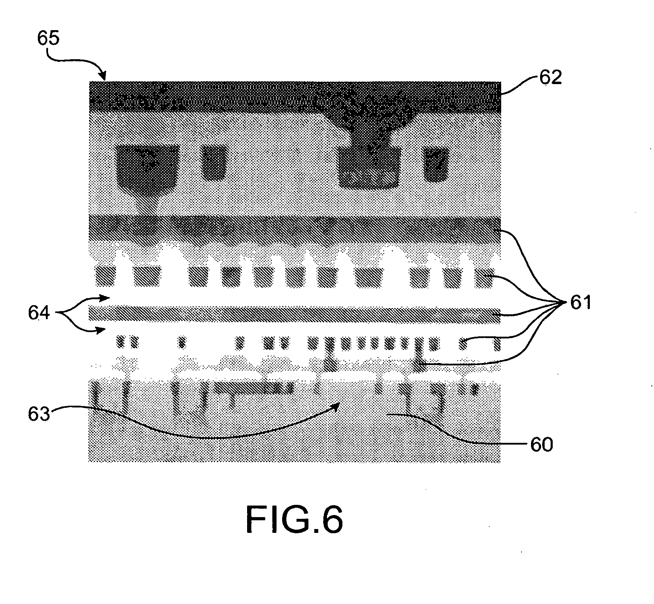

Au lieu d'utiliser un substrat SOI pour réaliser la structure guidante du dispositif laser de l'invention, il est possible de la placer à plusieurs nivéaux d'un circuit CMOS comme illustré sur la figure 6 qui est une photographie prise au microscope électronique à balayage d'une coupe d'un circuit CMOS. La partie basse 60 de la photographie représente le circuit CMOS. Les parties plus sombres sont des interconnexions métalliques 61 placées sur plusieurs niveaux, chacun de ces niveaux étant séparé par un matériau diélectrique. En surface enfin se trouvent des métallisations finales 62. Le dispositif laser de l'invention c'est-à-dire la structure guidante et la structure émettrice pourra se trouver à plusieurs niveaux différents référencés par les flèches 63, 64, 65. Sur cette figure, le dispositif laser n'est pas représenté, on veut juste montrer où elle pourrait être.

Le niveau référencé 63 correspond au circuit CMOS 60, le niveau 64 correspond au matériau diélectrique entre deux niveaux de métallisations 61 et le niveau 65 est sus-jacent aux métallisations finales 62.

On comprendra que différents changements et modifications peuvent être apportés sans sortir du cadre de l'invention, notamment en ce qui concerne les matériaux utilisés et les techniques de dépôt ou de gravure.

## Revendications

1. Dispositif laser comportant :
une source laser (10) incluant une structure émettrice (1) de lumière,
une structure guidante (40) pour délivrer la lumière générée par la structure émettrice, cette structure guidante (40) comprenant au moins une première portion (40.1) et une seconde portion (40.2), la première portion logeant un réseau de diffraction (3) qui constitue un réflecteur de la source laser et coopère avec la structure émettrice (1), la seconde portion (40.2) étant un guide d'onde qui délivre la lumière générée par la structure émettrice (1) et s'est propagée dans la première portion (40.1), la structure émettrice (1) est en technologie III-V ou en technologie II-VI et la structure guidante (40) en technologie silicium, **caractérisé en ce que** la source laser est à rétroaction distribuée, et la structure guidante (40) et la structure émettrice (1). de lumière étant empilées l'une sur l'autre.

2. Dispositif laser selon la revendication 1, dans lequel la structure guidante (40) a un coeur (41) entouré d'une enveloppe (42), la structure émettrice (1) et le coeur (41) de la structure guidante sont séparés par l'enveloppe (42) de la structure guidante.

3. Dispositif laser selon la revendication 2, dans lequel le coeur (41) de la structure guidante (40) au niveau de la première portion (40.1) est le réseau de diffraction (3) et au niveau de la seconde portion (40.2) le coeur du guide d' onde .

4. Dispositif laser selon la revendication 3, dans lequel le coeur de la première portion (40.1) comporte des zones (103.1) dans le même matériau que le coeurde la seconde portion (40.2), ces zones étant alternées avec des zones (104) en matériau diélectrique.

5. Dispositif laser selon l'une des revendicationprécédentes, dans lequel la source laser (10) est à pompage électrique.

6. Dispositif laser selon l'une des revendications 2 à 5, dans lequel le coeur de la seconde portion (40.2) du guide d'onde a un indice de réfraction qui est sensiblement constant.

7. Dispositif laser selon l'une des revendications précédentes, dans lequel le réseau de diffraction (3) comporte un déphaseur (4).

8. Dispositif laser selon l'une des revendications précédentes, dans lequel la structure guidante (40) comporte une troisième portion (40.3) qui forme un passage adiabatique entre la première portion (40.1) et la seconde portion (40.2).

9. Dispositif laser selon l'une des revendications précédentes, dans lequel la structure guidante (40) comporte de plus deux portions supplémentaires (40.4, 40.5) successives, en amont de la seconde portion (40.2), dont la première (40.4) loge un second réseau de diffraction (30) et la seconde (40.5) loge une cavité amplificatrice (31), la cavité
amplificatrice (31) étant insérée entre le premier réseau de diffraction (3) et le second réseau de diffraction (30).

10. Dispositif laser selon l'une des revendications précédentes, dans lequel la structure émettrice (1) est un empilement avec, à partir de la structure guidante (40), une seconde couche de prise de. contact électrique (6.2), une seconde couche formant gaine (5.2), une seconde couche espaceur (12.2), une couche active (11), une première couche espaceur (12.1), une première couche formant gaine (5.1), une première couche de prise de contact (6.1).

11. Dispositif laser selon la revendication 10, dans lequel chaque couche de prise de contact (6.1, 6.2) coopère avec une plage de contact électrique (7.1, 7.2).

12. Procédé de réalisation d'au moins un dispositif laser comportant une source laser (10) à
rétroaction distribuée comprenant une structure émettrice (1) de lumière et une structure guidante (40) pour délivrer la lumière générée par la structure émettrice (1), **caractérisé en ce qu'**il comporte les étapes suivantes :
réalisation de la structure émettrice (1) en technologie III-V ou II-VI,
réalisation de la structure guidante (40) en technologie silicium avec au moins une première portion (40.1) dans laquelle up réseau de diffraction (3) est inscrit et une seconde portion (40.2),
assemblage de la structure émettrice (1) et de la structure guidante (40) par adhésion moléculaire, en les empilant, de manière que le réseau de diffraction (3) soit un réflecteur de la source laser (10) et que la seconde portion (40.2) délivre la lumière générée par la structure émettrice (1).

13. Procédé selon la revendication 12, dans lequel la structure guidante (40) est réalisée dans un substrat SOI (100) ayant deux couches (101, 103) en silicium séparées par une couche diélectrique (102), l'une des couches en silicium (103) étant plus fine que l'autre, la structure guidante (40) ayant un coeur (41) qui est réalisé dans la couche en silicium la plus fine (103).

14. Procédé selon la revendication 13, dans lequel le réseau de diffraction (3) est obtenu par gravure de rainures dans la couche de silicium la plus fine (103) et rebouchage avec du matériau diélectrique (104).

15. Procédé selon l'une des revendications 13 ou 14, dans lequel on dépose une couche de matériau d'enterrement (105) sur le coeur (41) de la structure guidante (40).

16. Procédé selon l'un des revendications 12 à 15, dans lequel on réalise la structure émettrice (1) sur un substrat en matériau III-V ou II-VI (300),
en empilant depuis le substrat, successivement, une première couche de prise de contact (6.1), une première couche formant gaine (5.1), une première couche espaceur (12.1), une couche active (11), une seconde couche espaceur (12.2), une seconde couche formant gaine (5.2), une seconde couche de prise de contact électrique (6.2), ces couches étant en matériaux III-V ou II-VI.

17. Procédé selon la revendication 16, dans lequel on réalise la couche active (11) par empilement de plusieurs sous-couches (11.1, 11.2) pour obtenir un ou plusieurs puits quantiques.

18. Procédé selon l'une des revendications 16 ou 17, dans lequel une couche d'arrêt (301) est déposée sur le substrat (300), avant la première couche de prise de contact (6.1).

19. Procédé selon la revendication 18, dans lequel on élimine le substrat (300) en matériau III-V ou II-VI avec arrêt sur la couche d'arrêt (301) après l'assemblage.

20. Procédé selon la revendication 19, dans lequel on élimine la couche d'arrêt (301) après élimination du substrat (301) en matériau III-V ou II-VI.

21. Procédé selon l'une des revendications 16 à 20, dans lequel une couche d'accrochage ((302) est réalisée sur la seconde couche de contact (6.2) avant l'assemblage à la structure guidante (40).

22. Procédé selon la revendication 15 et la revendication 21, dans lequel un polissage de la couche d'accrochage (302) et de la couche de matériau d'enterrement (105) est réalisé pour faciliter l'assemblage.

23. Procédé selon l'une des revendications 16 à 22, dans lequel au moins une première plage de contact électrique (7.1) est déposée sur la première couche de prise de contact (6.1).

24. Procédé selon l'une des revendications 16 à 23, dans lequel au moins une zone de la seconde couche de prise de contact (6.2) est mise à nu avant d'y déposer au moins une seconde plage de contact électrique (7.2).

25. Procédé selon l'une des revendications 16 à 24, dans lequel lorsqu'on réalise plusieurs dispositifs laser simultanément, on subdivise la structure émettrice (1) en plusieurs morceaux par gravure au niveau de la seconde couche de prise de contact électrique (6.2).

## Patentansprüche

1. Laservorrichtung, umfassend:
eine Laserquelle (10), umfassend eine Emitterstruktur (1) für Licht,
eine Leitstruktur (40) zum Ausliefern des durch die Emitterstruktur erzeugten Lichts, wobei die Leitstruktur (40) wenigstens einen ersten Abschnitt (40.1) und einen zweiten Abschnitt (40.2) umfasst, wobei der erste Abschnitt ein Beugungsgitter (3) beherbergt, das einen Reflektor der Laserquelle darstellt und mit der Emitterstruktur (1) zusammenwirkt, wobei der zweite Abschnitt (40.2) ein Wellenleiter ist, der das durch die Emitterstruktur (1) erzeugte Licht, welches sich in dem ersten Abschnitt (40.1) ausbreitet, ausliefert, wobei die Emitterstruktur (1) in III-V-Technologie oder in II-VI-Technologie und die Leitstruktur (40) in Siliziumtechnologie ausgeführt ist, **dadurch gekennzeichnet, dass** die Laserquelle eine mit verteilter Rückkopplung ist und dass die Leitstruktur (40) und die Emitterstruktur (1) für Licht aufeinander gestapelt sind.

2. Laservorrichtung nach Anspruch 1,
wobei die Leitstruktur (40) einen Kern (41) umfasst, der von einer Hülle (42) umgeben ist, wobei die Emitterstruktur (1) und der Kern (41) der Leitstruktur durch die Hülle (42) von der Leitstruktur getrennt sind.

3. Laservorrichtung nach Anspruch 2,
wobei der Kern (41) der Leitstruktur (40) im ersten Abschnitt (40.1) das Beugungsgitter (3) ist und im zweiten Abschnitt (40.2) der Kern des Wellenleiters ist.

4. Laservorrichtung nach Anspruch 3,
wobei der Kern des ersten Abschnitts (40.1) Bereiche (103.1) aus dem gleichen Material umfasst wie der Kern des zweiten Abschnitts (40.2), wobei diese Bereiche mit Bereichen (104) aus dielektrischem Material abwechseln.

5. Laservorrichtung nach einem der vorangehenden Ansprüche, wobei die Laserquelle (10) elektrisch gepumpt ist.

6. Laservorrichtung nach einem der Ansprüche 2 bis 5,
wobei der Kern des zweiten Abschnitts (40.2) des Wellenleiters einen Brechungsindex aufweist, der im Wesentlichen konstant ist.

7. Laservorrichtung nach einem der vorangehenden Ansprüche, wobei das Beugungsgitter (3) einen Phasenschieber (4) umfasst.

8. Laservorrichtung nach einem der vorangehenden Ansprüche, wobei die Leitstruktur (40) einen dritten Abschnitt (40.3) umfasst, der eine adiabatische Passage zwischen dem ersten Abschnitt (40.1) und dem zweiten Abschnitt (40.2) bildet.

9. Laservorrichtung nach einem der vorangehenden Ansprüche, wobei die Leitstruktur (40) ferner zwei aufeinander folgende zusätzliche Abschnitte (40.4, 40.5) stromaufwärts des zweiten Abschnitts (40.2) umfasst, wobei der erste Abschnitt (40.4) ein zweites Beugungsgitter (30) aufnimmt und der zweite Abschnitt (40.5) einen Verstärkerhohlraum (31) aufnimmt, wobei der Verstärkerhohlraum (31) zwischen dem ersten Beugungsgitter (3) und dem zweiten Beugungsgitter (30) eingefügt ist.

10. Laservorrichtung nach einem der vorangehenden Ansprüche, wobei die Emitterstruktur (1) ein Stapel mit, von der Leitstruktur (40) ausgehend, einer zweiten elektrischen Kontaktaufnahmeschicht (6.2), einer zweiten hüllenbildenden Schicht (5.2), einer zweiten Abstandsschicht (12.2), einer aktiven Schicht (11), einer ersten Abstandsschicht (12.1), einer ersten hüllenbildenden Schicht (5.1) und einer ersten Kontaktaufnahmeschicht (6.1) ist.

11. Laservorrichtung nach Anspruch 10,
wobei jede Kontaktaufnahmeschicht (6.1, 6.2) mit einem elektrischen Kontaktbereich (7.1, 7.2) zusammenwirkt.

12. Verfahren zur Herstellung wenigstens einer Laservorrichtung, umfassend eine Laserquelle (10) mit verteilter Rückkopplung, umfassend eine Emitterstruktur (1) für Licht und eine Leitstruktur (40) zum Ausliefern des durch die Emitterstruktur (1) erzeugten Lichts, **dadurch gekennzeichnet, dass** es die folgenden Schritte umfasst:
Herstellung der Emitterstruktur (1) in III-V-Technologie oder in II-VI-Technologie,
Herstellung der Leitstruktur (40) in Siliziumtechnologie mit wenigstens einem ersten Abschnitt (40.1), in dem ein Beugungsgitter (3) eingebracht ist, und einem zweiten Abschnitt (40.2),
Zusammenfügen der Emitterstruktur (1) und der Leitstruktur (40) durch Molekularadhäsion, durch Stapeln derart, dass das Beugungsgitter (3) ein Reflektor der Laserquelle (10) ist, und so dass der zweite Abschnitt (40.2) das durch die Emitterstruktur (1) erzeugte Licht ausliefert.

13. Verfahren nach Anspruch 12,
wobei die Leitstruktur (40) in einem SOI-Substrat (100) ausgeführt wird, das zwei durch eine dielektrische Schicht (102) getrennte Siliziumschichten (101, 103) aufweist, wobei die eine der Siliziumschichten (103) dünner ist als die andere, wobei die Leitstruktur (40) einen Kern (41) aufweist, der in der dünnsten Siliziumschicht (103) ausgeführt ist.

14. Verfahren nach Anspruch 13, wobei das Beugungsgitter (3) durch Ätzen/Gravieren von Rillen in die dünnste Siliziumschicht (103) und Wiederverschließen mit dielektrischem Material (104) erhalten wird.

15. Verfahren nach Anspruch 13 oder 14,
wobei auf den Kern (41) der Leitstruktur (40) eine Schicht eines Abdeckungsmaterials (105) aufgebracht wird.

16. Verfahren nach einem der Ansprüche 12 bis 15,
bei welchem die Emitterstruktur (1) auf einem Substrat aus III-V- oder II-VI-Materialien (300) ausgeführt wird, indem von dem Substrat ausgehend aufeinander folgend eine erste Kontaktaufnahmeschicht (6.1), eine erste hüllenbildende Schicht (5.1), eine erste Abstandsschicht (12.1), eine aktive Schicht (11), eine zweite Abstandsschicht (12.2), eine zweite hüllenbildende Schicht (5.2) und eine zweite elektrische Kontaktaufnahmeschicht (6.2) gestapelt werden, wobei diese Schichten aus III-V- oder II-VI-Materialien gebildet werden.

17. Verfahren nach Anspruch 16,
wobei die aktive Schicht (11) durch Stapeln mehrerer Subschichten (11.1, 11.2) zum Erhalten eines oder mehrerer Quantentöpfe ausgeführt wird.

18. Verfahren nach Anspruch 16 oder 17,
wobei eine Stoppschicht (301) vor der ersten Kontaktaufnahmeschicht (6.1) auf dem Substrat (300) aufgebracht wird.

19. Verfahren nach Anspruch 18,
wobei das Substrat (300) aus den III-V- oder II-VI-Materialien eliminiert wird, mit Stopp an der Stoppschicht (301) nach dem Zusammenfügen.

20. Verfahren nach Anspruch 19, wobei die Stoppschicht (301) nach Eliminierung des Substrats (301) aus den III-V- oder II-VI-Materialien eliminiert wird.

21. Verfahren nach einem der Ansprüche 16 bis 20,
bei welchem eine Ankopplungsschicht (302) auf der zweiten Kontaktschicht (6.2) vor dem Anbringen an der Leitstruktur (40) ausgeführt wird.

22. Verfahren nach Anspruch 15 und 21,
bei welchem ein Polieren der Ankopplungsschicht (302) und der Schicht aus Einbettungsmaterial (105) durchgeführt wird, um das Zusammenfügen zu erleichtern.

23. Verfahren nach einem der Ansprüche 16 bis 22,
bei welchem wenigstens ein erster elektrischer Kontaktbereich (7.1) auf die erste Kontaktaufnahmeschicht (6.1) aufgebracht wird.

24. Verfahren nach einem der Ansprüche 16 bis 23,
bei welchem wenigstens ein Bereich der zweiten Kontaktaufnahmeschicht (6.2) freigelegt wird, bevor dort wenigstens ein zweiter elektrischer Kontaktbereich (7.2) aufgebracht wird.

25. Verfahren nach einem der Ansprüche 16 bis 24,
bei welchem, wenn mehrere Laservorrichtungen gleichzeitig realisiert werden, die Emitterstruktur (1) durch Ätzen/Gravieren auf Höhe der zweiten elektrischen Kontaktaufnahmeschicht (6.2) in mehrere Teile unterteilt wird.

## Claims

1. Laser device comprising:
a laser source (10), including a light emitting structure (1);
a guide structure (40) to deliver light generated by the emitting structure, this guide structure (40) comprising at least a first portion (40.1) and a second portion (40.2), the first portion housing a diffraction grating (3) that forms a reflector of the laser source and cooperates with the emitting structure (1), the second portion (40.2) being a waveguide that delivers light generated by the emitting structure (1) and propagated in the first portion (40.1), the emitting structure (1) is made using the III-V technology or II-VI technology, and the guide structure (40) is made using the silicon technology, **characterized in that** the laser source is with distributed retroaction and the guide structure (40) and the emitting structure (1) being stacked one on the other.

2. Laser device according to claim 1, in which the guide structure (40) has a core (41) surrounded by a cladding (42), the emitting structure (1) and the core (41) of the guide structure are separated by the cladding (42) of the guide structure.

3. Laser device according to claim 2, in which the core (41) of the guide structure (40) in the
first portion (40.1) is the diffraction grating (3) and in the second portion (40.2) is the waveguide core.

4. Laser device according to claim 3, in which the core in the first portion (40.1) comprises zones (103.1) made of the same material as the core in the second portion (40.2), these zones being alternated with zones (104) made of dielectric material.

5. Laser device according to one of the previous claims, in which the laser source (10) is electrically pumped.

6. Laser device according to one of claims 2 to 5, in which the core in the second portion (40.2) of the waveguide has an approximately constant refraction index.

7. Laser device according to one of the previous claims, in which the diffraction grating (3) comprises a phase shifter (4).

8. Laser device according to one of the previous claims, in which the guide structure (40) comprises a third portion (40.3) that forms an adiabatic passage between the first portion (40.1) and the second portion (40.2).

9. Laser device according to one of the previous claims, in which the guide structure (40) also comprises two additional successive portions (40.4, 40.5), on the input side of the second portion (40.2), the first of which (40.4) houses a second diffraction grating (30) and the second (40.5) houses an amplifying cavity (31), the amplifying cavity (31) being inserted
between the first diffraction grating (3) and the second diffraction grating (30).

10. Laser device according to the previous claims, in which the emitting structure (1) is a stack comprising, starting from the guide structure (40), a second electrical contact making layer (6.2), a second layer forming the cladding (5.2), a second spacer layer (12.2), an active layer (11), a first spacer layer (12.1), a first layer forming the cladding (5.1), and a first contact making layer (6.1).

11. Laser device according to claim 10, in which each contact making layer (6.1, 6.2) cooperates with an electrical contact strip (7.1, 7.2).

12. Method for making at least one laser device comprising a laser source (10) with distributed retroaction, comprising a light emitting structure (1) and a guide structure (40) to deliver light generated by the emitting structure (1), **characterised in that** it comprises the following steps:
make the emitting structure (1) using the III-V or II-VI technology;
make the guide structure (40) using the silicon technology with at least a first portion (40.1) in which a diffraction grating (3) is inscribed and a second portion (40.2);
assembly of the emitting structure (1) and the guide structure (40) by molecular bonding, by
stacking them, such that the diffraction grating (3) is a laser source reflector (10) and the second portion (40.2) outputs light generated by the emitting structure (1).

13. Method according to claim 12, in which the guide structure (40) is made from an SOI substrate (100) with two silicon layers (101, 103) separated by a dielectric layer (102), one of the silicon layers (103) being thinner than the other, the guide structure (40) having a core (41) made in the thinnest silicon layer (103).

14. Method according to claim 13, in which the diffraction grating (3) is obtained by etching grooves in the thinnest silicon layer (103) and filling in with dielectric material (104).

15. Method according to claim 13 or claim 14, in which a layer of embedding material (105) is deposited on the core (41) of the guide structure (40).

16. Method according to one of claims 12 to 15, in which the emitting structure (1) is made on a substrate made of a III-V or II-VI material (300), by stacking a sequence of layers, starting from the substrate, to obtain a first contact making layer (6.1), a first layer forming a cladding (5.1), a first spacer layer (12.1), an active layer (11), a second spacer layer (12.2), a second layer forming a cladding (5.2), a second electrical contact making layer (6.2), these layers being made of III-V or II-VI materials.

17. Method according to claim 16, in which the active layer (11) is made by stacking several sublayers (11.1, 11.2) to obtain one or several quantum wells.

18. Method according to one of claims 16 or 17, in which a stop layer (301) is deposited on the substrate (300), before the first contact making layer (6.1).

19. Method according to claim 18, in which the substrate (300) made of III-V or II-VI material is eliminated, stopping on the stop layer (301) after assembly.

20. Method according to claim 19, in which the stop layer (301) is eliminated after eliminating the substrate (301) made from III-V or II-VI material.

21. Method according to one of claims 16 to 20, in which a bond layer (302) is made on the second contact layer (6.2) before assembly to the guide structure (40).

22. Method according to one of claims 15 to 21, in which there is a polishing step of the bond layer (302) and the layer of embedding material (105) to facilitate assembly.

23. Method according to one of claims 16 to 22, in which at least a first electrical contact strip (7.1) is deposited on the first contact making layer (6.1).

24. Method according to one of claims 16 to 23, in which at least one zone of the second contact making layer (6.2) is exposed before at least one second electrical contact strip is deposited on it (7.2).

25. Method according to one of claims 16 to 24, in which if several laser devices are made simultaneously, the emitting structure (1) is subdivided into several portions by etching of the second electrical contact making layer (6.2).
